# EUROPEAN PATENT APPLICATION

(11) **EP 2 723 150 A2**
(43) Date of publication of application: **23.04.2014**
(21) Application number: 13181767.8
(22) Date of filing: 27.08.2013
(51) Int. Cl.: H05K 5/06

(54) **Electronic device**

(30) Priority: 22.10.2012 JP 2012233242
(71) Applicant: FUJITSU LIMITED, Kawasaki-shi, Kanagawa 211-8588 (JP)
(72) Inventor: Takita, Hiroyuki, Kawasaki-shi, Kanagawa 211-8588 (JP); Kajiwara, Yoshifumi, Kawasaki-shi, Kanagawa 211-8588 (JP); Fukuhara, Masahiro, Kawasaki-shi, Kanagawa 211-8588 (JP); Kubo, Hiroshi, Kawasaki-shi, Kanagawa 211-8588 (JP)
(74) Representative: Ward, James Norman

(57) **Abstract**

An electronic device including: a first case including a first wall portion formed with a first hook portion a second case including a second wall portion formed with a second hook portion; a gasket that is pressed by a face on an opposite side of the second hook portion so an interlocking face with the first hook portion and a bottom face of a housing groove; and a restriction wall portion that extends towards the second case side along a back face of an opposite side of the second wall portion to the first hook portion side, and that is set with a height such that a position of an upper end of the restriction wall portion is higher than an upper end of the gasket in a free state of the gasket prior to fitting the first hook portion together with the second hook portion.

## Description

### FIELD

The embodiments discussed herein are related to an electronic device.

### BACKGROUND

Electronic devices are known that include a first case with a first wall portion that is formed with a first hook portion projecting out towards a casing inside, and a second case with a second wall portion that is formed with a second hook portion projecting out towards the casing outside, the second hook portion fitting together with the first hook portion.

### Related Patent Documents

Japanese Laid-Open Patent Publication No. 2001-217561 In such electronic devices, a housing groove is formed to the first case, and a gasket is housed inside the housing groove, for example, in order to stop water between the first case and the second case. The gasket is pressed by a face on the opposite side of the second hook portion to an interlocking face with the first hook portion, and by a bottom face of the housing groove.

In such structures, when a leading end of the first hook portion and a leading end of the second hook portion abut each other during an assembly process of the first case to the second case, the second wall portion sometimes flexes due to a reaction force from the first wall portion, with the second hook portion moving towards the casing inside. When this occurs, the second hook portion over-rides the first hook portion and returns to its original position, this returning movement of the second hook portion imparting a twisting force on the gasket, with concern that there might be a reduction in the water resistance performance of the gasket.

### SUMMARY

Accordingly, it is an object in one aspect of the embodiment to enable the water resistance performance of a gasket to be secured.

According to an aspect of the embodiments, an electronic device includes: a first case including a first wall portion formed with a first hook portion projecting towards a casing inside; a second case including a second wall portion formed with a second hook portion that projects towards the casing outside and fits together with the first hook portion, and that forms the casing together with the first case; a gasket that is housed inside a housing groove formed in the first case, and that is pressed by a face on an opposite side of the second hook portion to an interlocking face with the first hook portion and a bottom face of the housing groove, stopping water between the first case and the second case; and a restriction wall portion that is formed to the first case, that extends towards the second case side along a back face of an opposite side of the second wall portion to the first hook portion side, and that is set with a height such that a position of an upper end of the restriction wall portion is higher than an upper end of the gasket in a free state of the gasket prior to fitting the first hook portion together with the second hook portion.

The object and advantages of the invention will be realized and attained by means of the elements and combinations particularly pointed out in the claims.

### BRIEF DESCRIPTION OF DRAWINGS

Fig. 1 is an exploded perspective view of an electronic device.
Fig. 2 is an enlarged perspective view of relevant portions of the rear case illustrated in Fig. 1.
Fig. 3 is an enlarged vertical cross-section of relevant portions of the casing illustrated in Fig. 1 taken at the position of a first hook portion.
Fig. 4 is an enlarged vertical cross-section of relevant portions of the casing illustrated in Fig. 1 taken at the position of a restriction wall portion.
Fig. 5 is a drawing to explain assembly of the casing illustrated in Fig. 1.

### DESCRIPTION OF EMBODIMENTS

Explanation follows regarding an exemplary embodiment of technology disclosed herein.

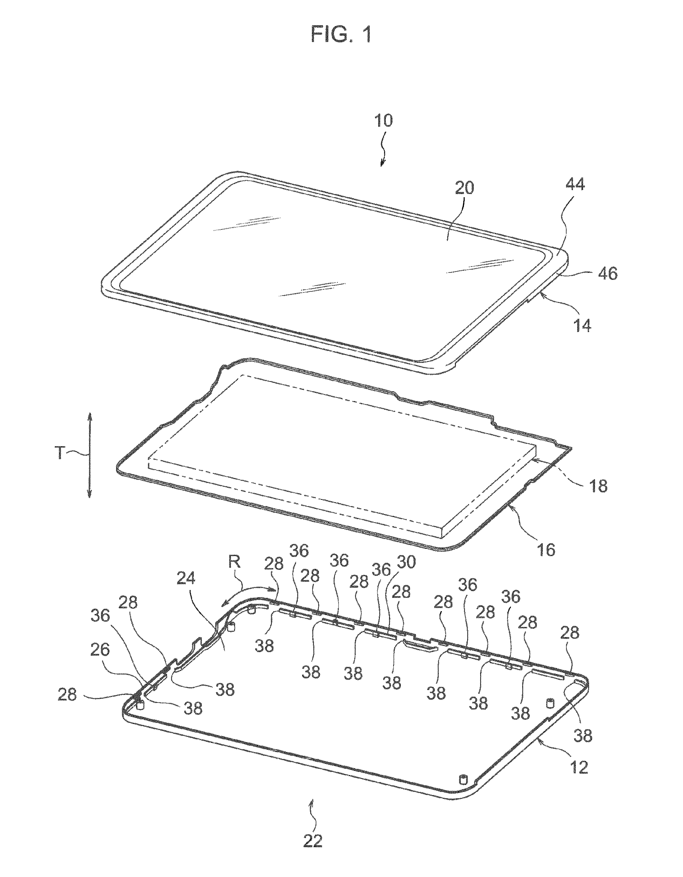

As illustrated in Fig. 1, an electronic device 10 according to the present exemplary embodiment includes a rear case 12, a front case 14, a gasket 16, an internal unit 18 and a display 20.

The rear case 12 and the front case 14 form a casing 22 of the electronic device 10. The rear case 12 and the front case 14 are divided in the casing 22 thickness direction (the arrow T direction). The internal unit 18, including for example a control board and a battery, is housed inside the front case 14 and the rear case 12. The display 20, that is for example a liquid crystal display, is assembled to the front case 14. The display 20 is driven by the control board of the internal unit 18. Note that the rear case 12 is an example of a first case, and the front case 14 is an example of a second case.

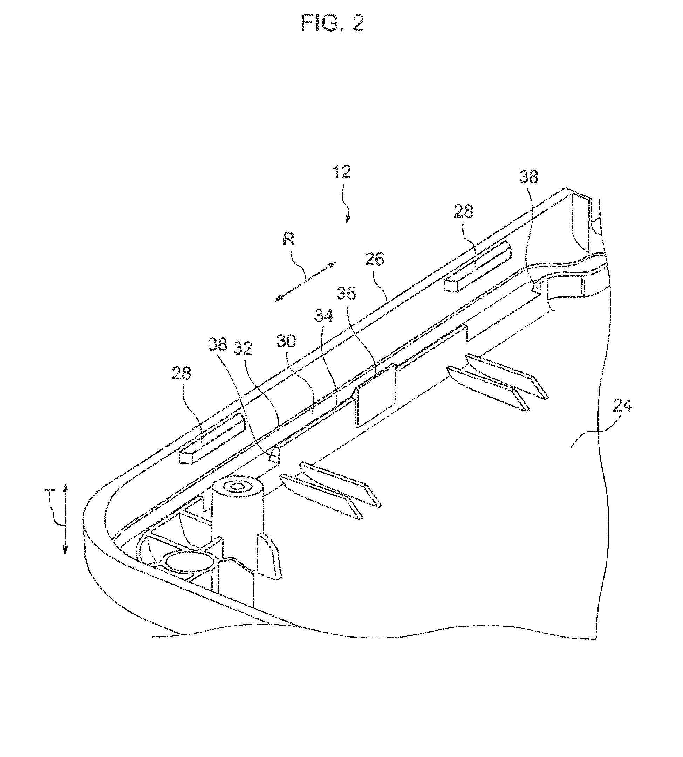

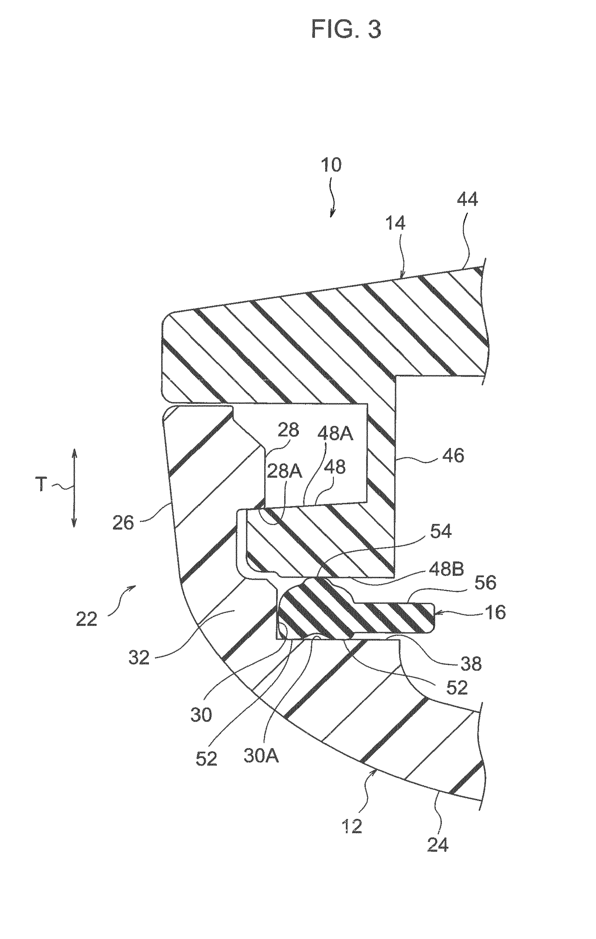

The rear case 12 includes a main body portion 24 extending in both the length and width directions of the casing 22, and a first wall portion 26 formed at an outer edge portion of the main body portion 24. The first wall portion 26 extends in the casing 22 thickness direction (the arrow T direction), that is the assembly direction of the rear case 12 and the front case 14, towards the front case 14 side, so as to span around the entire peripheral edge portion of the rear case 12. A leading end portion of the first wall portion 26 (an upper end portion on the front case 14 side) is formed with plural first hook portions 28 that project out towards the casing 22 inside (see also Fig. 2 and Fig. 3). The plural first hook portions 28 are formed at separations to each other along a direction (the arrow R direction) following the peripheral edge portion of the rear case 12.

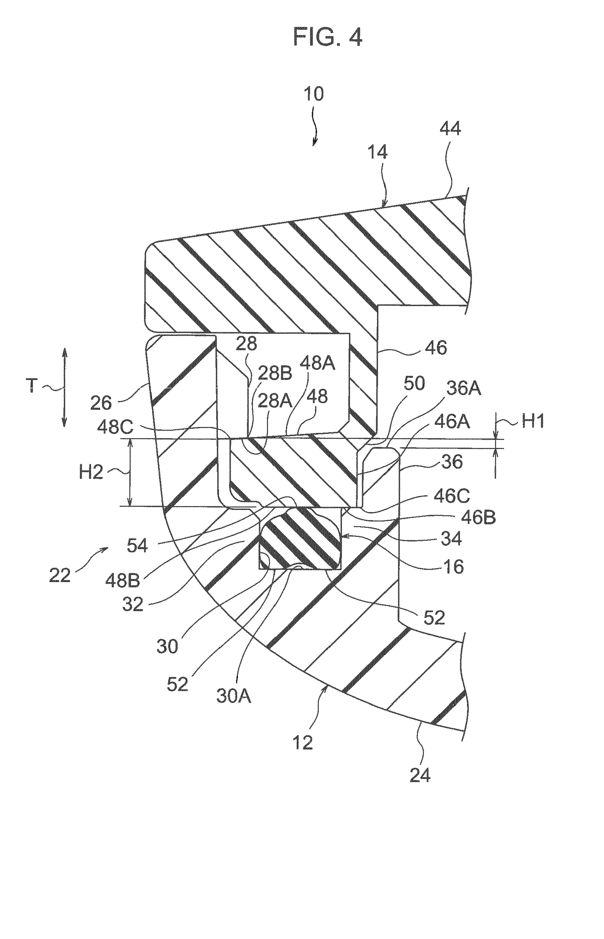

Moreover, as illustrated in Fig. 4, the main body portion 24 of the rear case 12 is formed with a housing groove 30 that is open towards the front case 14 side. The housing groove 30 is positioned further to the casing 22 inside than the first wall portion 26, and is formed in a ring shape around the peripheral edge portion of the rear case 12 (see also Fig. 2 and Fig. 3). The first wall portion 26 is formed at the side wall portion 32 that, out of a pair of side wall portions 32, 34 that form the housing groove 30, is positioned towards the casing 22 outside. The first wall portion 26 is formed at a position towards the casing 22 outside of an upper end of the side wall portion 32, with the thickness of the upper end of the side wall portion 32 being thicker than the thickness of a lower end of the first wall portion 26.

The rear case 12 is further formed with restriction wall portions 36 that restrict flexing of a second wall portion 46, described later. The restriction wall portions 36 extend towards the front case 14 side from an upper end of the side wall portion 34 that, out of the pair of side wall portions 32, 34 that form the housing groove 30, is positioned towards the casing 22 inside. The restriction wall portions 36 extend with straight line profiles towards the front case 14 side so as to follow a back face 46A on the opposite side of the second wall portion 46 to the side of the first hook portions 28 in a fitted state of the first hook portions 28 together with a second hook portion 48, described later.

The thickness, length and shape of the restriction wall portions 36 are set such that the restriction wall portions 36 have higher bending rigidity than the first wall portion 26. As illustrated in Fig. 2, the restriction wall portions 36 are formed at positions displaced with respect to the first hook portions 28 in the direction around the peripheral edge portion of the rear case 12 (in the arrow R direction). By way of an example, in the present exemplary embodiment the restriction wall portions 36 are formed at central portions between adjacent pairs of the first hook portions 28.

Plural cut-aways 38 are also formed to the side wall portion 34. The plural cut-aways 38 are formed at separations from each other in the direction around the rear case 12 peripheral edge portion. Each of the plural cut-aways 38 are formed at positions overlapping with the first hook portions 28 in the direction around the peripheral rear case 12 peripheral edge portion. Each of the plural cut-aways 38 penetrate the side wall portion 34 in the projection direction of the first hook portions 28. Note that during resin molding of the rear case 12, the cut-aways 38 are formed by a split mold (for example an insert die or core) used to mold the first hook portions 28.

As illustrated in Fig. 3 and Fig. 4, the front case 14 includes a main body portion 44 that faces the main body portion 24 of the rear case 12, and the second wall portion 46 that extends from the main body portion 44 towards the rear case 12 side along the casing 22 thickness direction (the arrow T direction). The second wall portion 46 is formed in a ring shape following the first wall portion 26, and is positioned to the casing 22 inside of the first wall portion 26. As illustrated in Fig. 4, the second wall portion 46 is formed over an extension line of the side wall portion 34. The back face 46A of the second wall portion 46 is formed with an avoidance portion 50 at positions corresponding to the restriction wall portions 36 to avoid interference (contact) between the second wall portion 46 and the restriction wall portions 36. A leading end portion (a rear case 12 side lower end portion) of the second wall portion 46 is formed with the second hook portion 48 projecting towards the casing 22 outside. The second hook portion 48 is formed extending around the entire periphery of the second wall portion 46. A leading end of the second hook portion 48 is positioned further to the casing 22 outside than the housing groove 30. Namely, the size and position of the second hook portion 48 are set so as to cover over the housing groove 30.

As illustrated in Fig. 3 and Fig. 4, the second hook portion 48 fits together (anchors) with the first hook portions 28 in the casing 22 thickness direction from the housing groove 30 side of the first hook portions 28. The front case 14 and the rear case 12 are accordingly assembled together due to the first hook portions 28 and the second hook portion 48 thus fitting together with each other. Mutually interlocking faces 28A, 48A of the first hook portions 28 and the second hook portion 48 are respectively formed in directions intersecting with (orthogonal to) the casing 22 thickness direction. A face 48B on the opposite side of the second hook portion 48 to the interlocking face 48A that fits together with the first hook portions 28 is moreover formed along a direction intersecting with (orthogonal to) the casing 22 thickness direction.

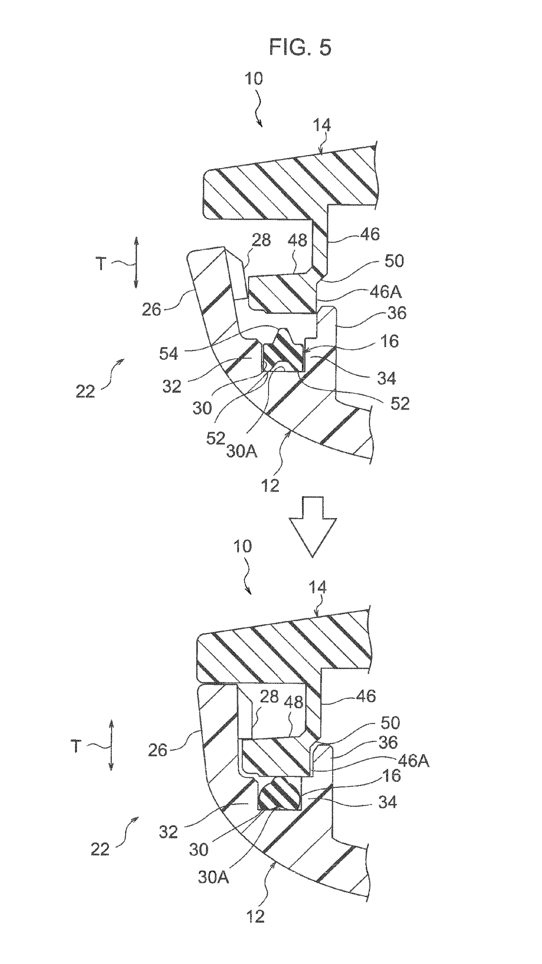

The gasket 16 is formed from a resilient material such as rubber. The gasket 16 is formed in a ring shape around the housing groove 30, and is housed inside the housing groove 30. The gasket 16 includes a pair of leg portions 52 and a single protrusion portion 54. The pair of leg portions 52 are aligned side-by-side in the gasket 16 width direction, and respectively project out towards a bottom face 30A side of the housing groove 30. The protrusion portion 54 projects out from a width direction central portion of the gasket 16 towards the second hook portion 48 side (see also the upper drawing in Fig. 5).

As illustrated in Fig. 3, the gasket 16 is also formed with projected portions 56 at positions corresponding to the cut-aways 38 described above. The projected portions 56 project out towards the ring-shaped gasket 16 inside (namely towards the casing 22 inside). The projected portions 56 fit together with the cut-aways 38, thereby positioning the gasket 16 in the direction around the rear case 12 peripheral edge portion.

As illustrated in Fig. 3 and Fig. 4, in a fitted state of the first hook portions 28 together with the second hook portion 48, the gasket 16 is pressed (resiliently compressed) by the face 48B on the opposite side to the interlocking face 48A of the second hook portion 48 and the bottom face 30A of the housing groove 30. The gasket 16 stops water between the rear case 12 and the front case 14 in the pressed state of the gasket 16 by the face 48B of the second hook portion 48 and the bottom face 30A of the housing groove 30. As illustrated in the upper drawing in Fig. 5, the gasket 16 is in a free state (a non-resiliently deformed state) in a state prior to fitting the first hook portions 28 together with the second hook portion 48.

The height of the restriction wall portions 36 is set such that in the state prior to fitting the first hook portions 28 together with the second hook portion 48, the position of upper ends of the restriction wall portions 36 is higher than the the upper end of the gasket 16 in the free state. Moreover, the height of the second wall portion 46, the thickness of the second hook portion 48, and the height of the restriction wall portions 36, for example, are respectively set such that the back face 46A of the second wall portion 46 contacts the restriction wall portions 36 when the leading ends of the first hook portions 28 and the leading end of the second hook portion 48 abut each other (before the second hook portion 48 over-rides the first hook portions 28).

By way of an example, in the present exemplary embodiment the restriction wall portions 36 are positioned at a lower position than the first hook portions 28 in the casing 22 thickness direction (the arrow T direction) that is the assembly direction of the rear case 12 and the front case 14. Moreover, as illustrated in Fig. 4, a casing 22 thickness direction dimension H1 between the first hook portions 28 and the restriction wall portions 36 is set smaller than a casing 22 thickness direction dimension H2 between the interlocking face 48A of the second hook portion 48 and a lower end face 46B that is a height direction end face of the second wall portion 46.

More specifically, the dimension H1 is a casing 22 thickness direction dimension between lower edges 28B of the leading end faces of the first hook portions 28 and upper edges 36A of the restriction wall portions 36. The dimension H2 is a casing 22 thickness direction dimension between the leading edge 48C of the interlocking face 48A of the second hook portion 48 and a back face side edge portion 46C of the lower end face 46B of the second wall portion 46.

Next, explanation follows regarding operation and advantageous effects of the present exemplary embodiment.

As described above, according to the present exemplary embodiment the rear case 12 is formed with the restriction wall portions 36. The restriction wall portions 36 extend towards the front case 14 side following the back face 46A on the opposite side of the second wall portion 46 to the side of the first hook portions 28. As illustrated in the upper drawing in Fig. 5, in the assembly process of the rear case 12 and the front case 14, flexing of the second wall portion 46 towards the casing 22 inside can be restricted by the restriction wall portions 36 even in an abutted state of the leading ends of the first hook portions 28 and the leading end of the second hook portion 48. Movement of the second hook portion 48 towards the casing 22 inside can accordingly be suppressed.

The height of the restriction wall portions 36 is moreover set such that the position of the upper ends of the restriction wall portions 36 is higher than the upper end of the gasket 16 in the free state of the gasket 16, a state prior to fitting the first hook portions 28 together with the second hook portion 48. Flexing of the second wall portion 46 towards the casing 22 inside is accordingly restricted by the restriction wall portions 36, thereby positioning the second hook portion 48, before the second hook portion 48 makes contact with the gasket 16. Accordingly, as illustrated the lower drawing in Fig. 5, the second hook portion 48 presses the gasket 16 straight towards the bottom face 30A side of the housing groove 30, even when the second hook portion 48 over-rides the first hook portions 28 and the second hook portion 48 and the first hook portions 28 are fitted together. As a result, twisting force can be suppressed from acting on the gasket 16, thereby enabling the water resistance performance of the gasket 16 to be secured.

The first hook portions 28 are moreover formed at the leading end portion of the first wall portion 26 that extends from the rear case 12 towards the front case 14 side. The first wall portion 26 can accordingly be made to flex towards the casing 22 outside in a state in which the leading end portions of the first hook portions 28 and the leading end portion of the second hook portion 48 abut, and flexing of the second wall portion 46 is restricted by the restriction wall portions 36. The first hook portions 28 can be moved towards the casing 22 outside, thereby enabling the first hook portions 28 and the second hook portion 48 to be fitted together smoothly.

The restriction wall portions 36 are positioned at a lower position than the first hook portions 28 in the casing 22 thickness direction (the arrow T direction) that is the assembly direction of the rear case 12 and the front case 14. Restriction of the flexing of the second wall portion 46 at an initial fitting together stage when the leading ends of the first hook portions 28 first make contact with the leading end of the second hook portion 48 can accordingly be suppressed by the restriction wall portions 36. The load required to fit together the first hook portions 28 and the second hook portion 48 at the initial fitting together stage of the cut-away portions 38 and the second hook portion 48 can accordingly be reduced.

As illustrated in Fig. 4, the casing 22 thickness direction dimension H1 between the first hook portions 28 and the restriction wall portions 36 is set smaller than the casing 22 thickness direction dimension H2 between the interlocking face 48A of the second hook portion 48 and the lower end face 46B of the second wall portion 46. Flexing of the second wall portion 46 towards the casing 22 inside can accordingly be suppressed by the restriction wall portions 36 at least at a later fitting together state when the second hook portion 48 is attempting to over-ride the first hook portions 28.

The restriction wall portions 36 are moreover formed at positions displaced with respect to the first hook portions 28 in the direction around the rear case 12 peripheral edge portion. Slight flexing of the second wall portion 46 can accordingly be permitted at the positions corresponding to the first hook portions 28. The force required to fit together the first hook portions 28 and the second hook portion 48 can accordingly be reduced, thereby enabling the first hook portions 28 and the second hook portion 48 to be fitted together even more smoothly Note that flexing of the second wall portion 46 in such cases is set within a range so as to prevent twisting of the gasket 16.

As illustrated in Fig. 3, the gasket 16 is formed with the projected portions 56, with the projected portions 56 fitting together with the cut-aways 38. Positional displacement of the gasket 16 can accordingly be suppressed.

The cut-aways 38 are moreover formed during resin molding of the rear case 12 by a split mold (for example an insert die or core) used to mold the first hook portions 28. The structure can accordingly be simplified due to employing the cut-aways 38 to perform positioning of the gasket 16.

Explanation follows regarding modified examples of the present exemplary embodiment.

In the present exemplary embodiment, the first hook portions 28, the housing groove 30 and the restriction wall portions 36 are formed to the rear case 12, and the second hook portion 48 is formed to the front case 14. However the first hook portions 28, the housing groove 30, and the restriction wall portions 36 may be formed to the front case 14, and the second hook portion 48 may be formed to the rear case 12. In such cases, the rear case 12 is an example of the second case, and the front case 14 is an example of the first case.

The rear case 12 and the front case 14 are divided in the casing 22 thickness direction (the arrow T direction), however the rear case 12 and the front case 14 may be divided in a different direction.

The restriction wall portions 36 are positioned at a lower position than the first hook portions 28 in the casing 22 thickness direction. However configuration may be made such that leading end side portions of the restriction wall portions 36 overlap with the first hook portions 28 in the casing 22 thickness direction.

The avoidance portion 50 is formed to the back face 46A of the second wall portion 46 in order to avoid interference (contact) between the second wall portion 46 and the restriction wall portions 36. However the avoidance portion 50 may be omitted from the back face 46A of the second wall portion 46 in cases in which the restriction wall portions 36 are formed to the casing 22 inside of the second wall portion 46.

The electronic device 10 is provided with the display 20, however the display 20 may be omitted.

Note that the plural modified examples described above may be combined as appropriate. Explanation has been given of an exemplary embodiment of technology disclosed herein, however the technology disclosed herein is not limited to the above, and obviously various other modifications other than those described above may be implemented within a range not departing from the spirit of the technology disclosed herein.

According to technology disclosed herein, the water resistance performance of the gasket can be secured.

All cited documents, patent applications and technical standards mentioned in the present specification are incorporated by reference in the present specification to the same extent as if the individual cited documents, patent applications and technical standards were specifically and individually incorporated by reference in the present specification.

## Claims

1. An electronic device(10) comprising:
a first case(12) including a first wall portion(26) formed with a first hook portion(28) projecting towards a casing(22) inside;
a second case(14) including a second wall portion(46) formed with a second hook portion(48) that projects towards the casing(22) outside and fits together with the first hook portion(28), and that forms the casing(22) together with the first case(12);
a gasket(16) that is housed inside a housing groove(30) formed in the first case(12), and that is pressed by a face(48B) on an opposite side of the second hook portion(48) to an interlocking face(48A) with the first hook portion(28) and a bottom face(30A) of the housing groove(30), stopping water between the first case(12) and the second case(14); and
a restriction wall portion(36) that is formed to the first case(12), that extends towards the second case(14) side along a back face(46A) of an opposite side of the second wall portion(46) to the first hook portion(28) side, and that is set with a height such that a position of an upper end of the restriction wall portion(36) is higher than an upper end of the gasket(16) in a free state of the gasket(16) prior to fitting the first hook portion(28) together with the second hook portion(48).

2. The electronic device(10) of claim 1, wherein:
the restriction wall portion(36) is positioned at a lower position than the first hook portion(28) in an assembly direction(T) of the first case(12) and the second case(14); and
a dimension(H1) between the first hook portion(28) and the restriction wall portion(36) in the assembly direction(T) of the second case(14) and the first case(12) is set smaller than a dimension(H2) between the interlocking face(48A) of the second hook portion(48) and a height direction lower end face(46B) of the second wall portion(46) in the assembly direction(T) of the first case(12) and the second case(14).

3. The electronic device(10) of either claim 1 or claim 2, wherein the restriction wall portion(36) is formed at a position displaced with respect to the first hook portion(28) in a direction(R) around a peripheral edge portion of the first case(12).

4. The electronic device(10) of any one of claim 1 to claim 3, wherein:
the first wall portion(26) extends towards the second case(14) side in the assembly direction(T) of the first case(12) and the second case(14); and
the second wall portion(46) is positioned further to the casing(22) inside than the first wall portion(26), and also extends towards the first case(12) side along assembly direction(T) of the first case(12) and the second case(14).

5. The electronic device(10) of any one of claim 1 to claim 4, wherein:
the housing groove(30) is positioned further to the casing(22) inside than the first wall portion(26);
the second wall portion(46) is formed over an extension line of a side wall portion(34) that is positioned further towards the casing(22) inside out of a pair of side wall portions(32,34) that form the housing groove(30);
the restriction wall portion(36) extends towards the second case(14) from an upper end of the side wall portion(34) that, out of the pair of side wall portions(32,34) that form the housing groove(30), is positioned further towards the casing(22) inside; and
an avoidance portion(50) is formed to the back face(46A) of the second wall portion(46) at a position corresponding to the restriction wall portion(36).

6. The electronic device(10) of any one of claim 1 to claim 5, wherein:
the side wall portion(34) that, out of the pair of side wall portions(32,34) that form the housing groove(30), is positioned further towards the casing(22) inside is formed with a cut-away(38) at a position overlapping with the first hook portion(28) in a direction(R) around a peripheral edge portion of the first case(12), the cut-away(38) penetrating the side wall portion(34) in the first hook portion(28) projection direction.

7. The electronic device(10) of claim 6, wherein the gasket(16) is formed with a projected portion(56) that fits together with the cut-away(38).
